# FASCICULE DE BREVET EUROPEEN

(11) **EP 1 332 517 B1**
(45) Date de publication et mention de la délivrance du brevet: **09.12.2009**
(21) Numéro de dépôt: 01974440.8
(22) Date de dépôt: 05.10.2001
(51) Int. Cl.: H01L 21/306, H01L 21/18, C30B 33/06

(54) **PROCEDE DE REVELATION DE DEFAUTS CRISTALLINS ET/OU DE CHAMPS DE CONTRAINTES A L'INTERFACE D'ADHESION MOLECULAIRE DE DEUX MATERIAUX SOLIDES**
VERFAHREN ZUM AUFZEIGEN VON KRISTALLFEHLERN UND/ODER SPANNUNGSFELDERN IN DER KONTAKTFLÄCHE VON ZWEI VERBUNDENEN MATERIALEN
METHOD FOR REVEALING CRYSTALLINE DEFECTS AND/OR STRESS FIELD DEFECTS AT THE MOLECULAR ADHESION INTERFACE OF TWO SOLID MATERIALS

(30) Priorité: 06.10.2000 FR 0012796
(43) Date de publication de la demande: 06.08.2003
(73) Titulaire: COMMISSARIAT A L'ENERGIE ATOMIQUE, 75015 Paris (FR)
(72) Inventeur: FOURNEL, Franck, F-69003 LYON (FR); MORICEAU, Hubert, F-38120 SAINT-EGREVE (FR); MAGNEA, Noel, F-38430 MOIRANS (FR)
(74) Mandataire: Poulin, Gérard
(86) Numéro de dépôt international: PCT/FR2001/003074
(87) Numéro de publication internationale: WO 2002/029876

(56) Documents cités:
- WO-A-99/05711
- US-A- 5 981 400
- US-B1- 6 329 070
- GAFITEANU ET AL.: "Twist boundaries in silicon: a model system" MICROSCOPY OF SEMICONDUCTOR MATERIALS 1993, PROC. OF THE ROYAL MICROSCOPICAL SOCIETY CONF., 5 - 8 avril 1993, pages 87-90, XP008001254 OXFORD, GB
- FOURNEL F ET AL: "Ultra thin silicon films directly bonded onto silicon wafers" MATERIALS SCIENCE AND ENGINEERING B,CH,ELSEVIER SEQUOIA, LAUSANNE, vol. 73, no. 1-3, avril 2000 (2000-04), pages 42-46, XP004192018 ISSN: 0921-5107

## Description

### Domaine technique

L'invention concerne un procédé permettant de révéler des défauts ou des contraintes dans une structure, notamment pour réaliser des nanostructures ou des microstructures, ce procédé mettant en oeuvre un collage par adhésion moléculaire de deux éléments cristallins.

### Etat de la technique antérieure

Il est connu que lors d'un collage moléculaire de deux matériaux cristallins, il apparaît à l'interface de collage un réseau nanométrique ou micrométrique de champs de contraintes et/ou de défauts cristallins.

Le document WO 99/05711 divulgue un procédé mettant en oeuvre un collage moléculaire de deux plaquettes en matériau cristallin pour obtenir un réseau nanométrique ou micrométrique de champs de contraintes et/ou de défauts cristallins. Par une méthode d'amincissement chimique ou mécanique, l'une des plaquettes est amincie suffisamment pour permettre la révélation du réseau de défauts cristallins ou de champs de contraintes. Si un matériau est ensuite déposé sur le film constitué par la plaquette amincie, ce matériau s'organise en un réseau qui dépend directement du réseau de défauts cristallins et/ou de champs de contraintes induit à l'interface de collage et révélé par le film mince.

Il est connu par ailleurs que les dislocations présentes dans un matériau cristallin sont des lieux privilégiés de précipitation d'impuretés ou de dopants. On peut à ce sujet se référer aux articles suivants :
- "Low-temperature gettering of trace iron and copper by misfit dislocations in Si/Si(Ge) epitaxy" par D.M. LEE et al., paru dans Applied Physics Letters, Vol. 65, N° 3, 18 juillet 1994, pages 350-352 ;
- "Gettering of Au to dislocations and cavities in silicon" par J. WONG-LEUNG et al., paru dans Applied Physics Letters, Vol. 67, N°3, 17 juillet 1995, pages 416-418.

Selon ces articles, les dislocations, qui sont le lieu privilégié de précipitations, sont réparties de façon aléatoire dans un volume et ne sont pas de nature unique ni parfaitement maîtrisées.

### Exposé de l'invention

L'invention a pour objet de rendre utilisable un réseau manométrique ou micrométrique de champs de contraintes et/ou de défauts cristallins pour utiliser ce réseau de façon différente que les méthodes actuelles.

L'invention a donc pour objet un procédé tel que défini dans la revendication 1.

Le budget thermique peut être apporté au cours d'une opération ayant pour objet de modifier au moins l'une des propriétés du matériau présenté par la face libre du film mince. Ces propriétés peuvent comprendre sa nature, sa topologie de surface et ses champs de contraintes internes. Il peut aussi être apporté au cours d'une opération ayant pour objet d'effectuer un dépôt sur la face libre du film mince.

L'introduction d'espèces chimiques dans le film mince peut être réalisée par une méthode choisie parmi l'implantation ionique et la diffusion. Les espèces chimiques introduites peuvent être des espèces qui précipitent ou se concentrent sur les défauts cristallins et/ou sous l'influence des champs de contraintes.

Le traitement du film mince peut être réalisé localement pour révéler une ou plusieurs zones du réseau de défauts cristallins et/ou de champs de contraintes.

Si l'étape d'amincissement fournit plusieurs films minces adhérents, l'étape de traitement peut s'appliquer à un ou à plusieurs desdits films minces.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- La figure 1 est une vue en coupe transversale de deux substrats dont des faces présentant un réseau cristallin sont mises en contact adhérant, un réseau de défauts cristallins et/ou de champs de contraintes s'étant formés au voisinage de l'interface de collage, conformément à la première étape du procédé selon l'invention,
- la figure 2 montre la structure de la figure 1 après amincissement de l'un des substrats conformément à la deuxième étape du procédé selon l'invention,
- la figure 3 montre la structure de la figure 2 après la mise en oeuvre de la troisième étape du procédé selon l'invention.

### Description détaillée de modes de réalisation de l'invention

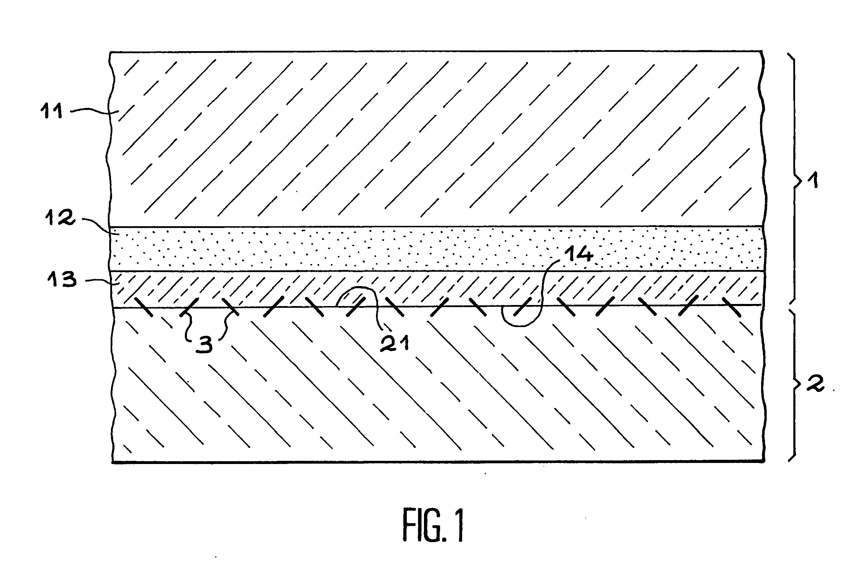

La figure 1 est une vue transversale en coupe montrant un substrat SOI 1 collé à une plaquette de silicium 2. Le substrat SOI 1 est par exemple un disque de 4 pouces (10,16 cm) de diamètre, constitué de la superposition d'une plaquette 11 de silicium, d'une couche 12 de SiO₂ de 400 nm d'épaisseur et d'une couche 13 de silicium de 200 nm d'épaisseur. La couche 13 présente une face de collage 14. Le silicium de la plaquettes 11 et le silicium de la couche 13 sont chacun de type P dopé à 10¹⁵-10¹⁶ atomes/cm³. La couche 13 présente une surface orientée dans la direction <100>. La plaquette 2, de 4 pouces (10,16 cm) de diamètre, est également en silicium de type P dopée à 10¹⁵-10¹⁶ atomes/cm³ et présente une surface orientée dans la direction <100>. La plaquette 2 présente une face de collage 21.

La figure 1 montre la structure obtenue après collage par adhésion moléculaire de la face 21 de la plaquette 2 sur la face 14 du substrat SOI 1. Avant collage, les faces 21 et 14 ont été traitées par une méthode de l'art connu de façon à obtenir l'adhésion moléculaire. Le substrat 1 et la plaquette 2 sont collés de façon que les faces 14 et 21 présentent des réseaux cristallins décalés comme l'enseigne le document WO 99/05711. La structure peut être soumise à un traitement thermique qui permet de renforcer le scellement entre les faces 12 et 21.

Le collage par adhésion moléculaire provoque la formation d'un réseau de défauts cristallins et/ou de champs de contraintes figurées symboliquement sous la référence 3 sur la figure 1.

L'étape suivante du procédé consistera à amincir le substrat 1. Pour cela, le substrat SOI 1 est aminci à partir de sa face arrière par une méthode mécanique de l'art connu. Cet amincissement mécanique est par exemple arrêté à plus de 10 µm de l'interface de collage 14/21 donc dans la plaquette 11 en silicium. Le reste du silicium de la plaquette 11 est éliminé par exemple par une attaque chimique utilisant du TMAH (hydroxyde de triméthylammonium) à 80°C. D'autres types d'amincissement peuvent être utilisés. Cette attaque chimique s'arrête sur la face arrière de la couche d'oxyde 12. La couche d'oxyde 12 est alors éliminée par attaque au moyen d'une solution d'acide fluorhydrique (10% HF : H₂O).

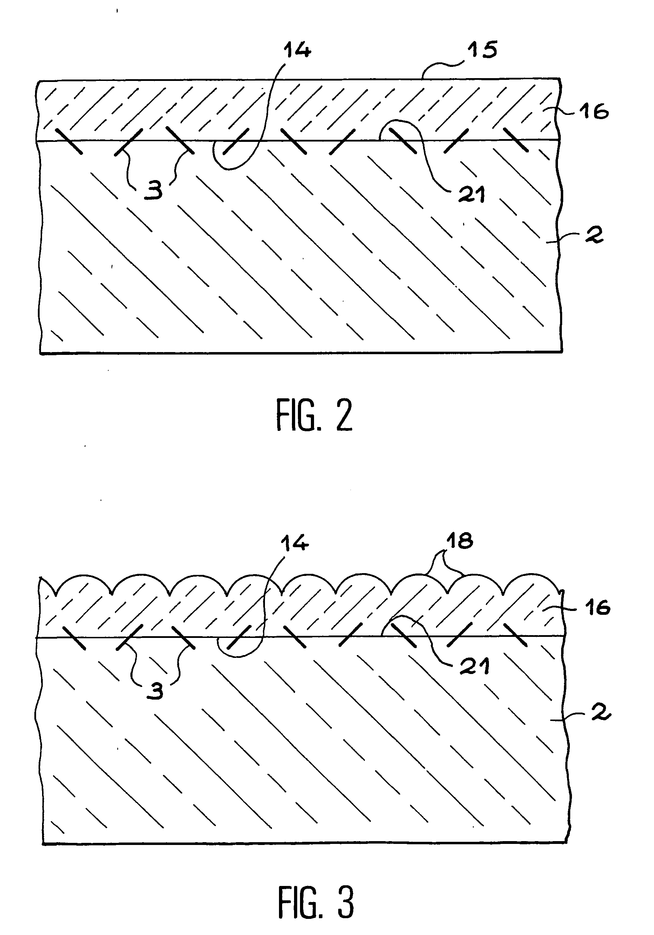

Ensuite, un traitement thermique est mis en oeuvre pour à la fois renforcer l'énergie de scellement et reformer une couche d'oxyde en consommant une partie du silicium de la couche 13 exposée. Par un contrôle de l'épaisseur de l'oxyde formé, l'épaisseur du silicium de la couche 13 restant est amenée à environ 10 nm pour constituer le film mince 16. Cet oxyde sacrificiel est ensuite enlevé par une attaque HF (10% HF : H₂O). On obtient la structure représentée à la figure 2. La surface libre 15 du film 16 ne révèle pas de réseau de défauts cristallins ou de champs de contraintes. Un tel réseau reste limité au voisinage de l'interface de collage 14/21.

Une fois l'amincissement réalisé, en fonction du substrat de départ, il peut y avoir plusieurs films minces superposés sur la plaquette.

L'étape suivante du procédé consiste à traiter le film mince 16 pour que sa face libre 15 révèle le réseau de défauts cristallins ou de champs de contraintes existant au voisinage de l'interface de collage 14/21.

Le réseau de défauts cristallins ou de champs de contraintes peut être révélé par l'apport d'un budget thermique. Ce budget thermique peut être apporté lors d'un recuit sous différentes atmosphères (azote, oxygène, argon ou tout autre gaz), ou sous vide, lors d'une épitaxie, lors d'une oxydation ou par une combinaison de ces techniques. Ce budget thermique a pour but de provoquer un changement du volume des zones de contraintes et/ou des défauts cristallins. Ce changement de volume provoque une modification de la topologie de la surface libre 15 du film 16. Il conduit à l'apparition en surface d'un réseau de contraintes ou d'une modification topologique périodique de la surface dépendant totalement ou en partie du réseau des champs de contraintes et/ou du réseau de défauts cristallins présents à et/ou au voisinage de l'interface de collage dont on a modifié le volume. En outre, le pas de la topologie modifiée peut être un multiple du pas du réseau de champs de contraintes et/ou du réseau de défauts cristallins.

La figure 3 montre, sous la référence 18, un exemple de modulation topographique de la surface du film 16 après un recuit sous vide à une température de 800°C. Cette modulation de la surface est périodique et la période de modulation dépend de la période des réseaux de dislocations présents à l'interface de collage 14/21, c'est-à-dire à environ 10 nm sous la surface libre du film 16.

Le réseau de défauts cristallins ou de champs de contraintes peut aussi être révélé par l'introduction d'espèces chimiques dans le film mince. Ces espèces chimiques peuvent provenir de particules métalliques ou magnétiques. Il peut s'agir de gaz, comme par exemple l'hydrogène et/ou l'hélium ou d'un ou plusieurs autres éléments que l'on peut introduire dans le film mince 16 ou dans la plaquette 2, par exemple Er, Fe, Co, Ni, Mn, Au, Cu. L'introduction d'espèces peut se faire par diffusion ou implantation ionique par exemple. Elle peut consister à introduire plusieurs espèces différentes en une ou plusieurs étapes.

L'introduction d'espèces chimiques peut être suivie et/ou précédée et/ou se faire en même temps que l'apport d'un budget thermique qui peut être réparti en plusieurs phases. Ce budget thermique peut, en plus des différents effets cités ci-dessus, faciliter la diffusion des différentes espèces introduites vers les défauts cristallins. Cela peut permettre de diminuer ou d'augmenter localement le volume du réseau de champs de contraintes et/ou de modifier la nature des défauts cristallins qui sont en réseau. Avantageusement, cette modification de volume et/ou de nature des contraintes et/ou des défauts cristallins peut se répercuter en surface.

Les espèces introduites peuvent de plus précipiter sur les défauts cristallins et/ou suivant l'influence des champs de contraintes. On obtient alors un réseau enterré des espèces introduites dépendant totalement ou en partie du réseau de champs de contraintes et/ou du réseau des défauts cristallins. En outre, le pas du réseau d'espèces enterrées peut être multiple du pas du réseau de champs de contraintes et/ou du réseau de défauts cristallins. Par exemple, dans le cas d'une introduction de cuivre, on peut obtenir un réseau de fils nanométriques au pas nanométrique à une interface Si/Si, que l'on peut faire apparaître en surface.

Egalement, dans le cas d'un matériau magnétique introduit, on peut obtenir un réseau de fils ou de plots magnétiques qui peut ensuite servir cette fois par effet de réseau de champs magnétiques à l'organisation, par exemple, de matériaux magnétiques en surface. Ce réseau de fils ou de plots peut aussi être directement utilisé, enterré ou non dans le film ou dans le substrat.

Le réseau de défauts cristallins ou de champs de contraintes peut aussi être révélé par au moins une attaque chimique et/ou électrochimique et/ou ionique et/ou photochimique et/ou une attaque mécanique. Il peut s'agir par exemple d'une gravure RIE ou d'un bombardement ionique. Ce traitement peut se faire après et/ou avant et/ou pendant l'apport d'un budget thermique conduisant à la modification du réseau de contraintes et/ou de défauts cristallins. Il y a bien modification du volume des contraintes et/ou des défauts cristallins en ce sens où le volume de l'extension des champs de contraintes et/ou des défauts cristallins est modifié. La localisation de cette attaque dépend totalement ou en partie du réseau de champs de contraintes et/ou du réseau de défauts cristallins. En outre, le pas de cette attaque localisée peut être un multiple du pas de réseau de champs de contraintes et/ou du réseau de défauts cristallins. Par exemple, la formation de silicium poreux par une attaque électrochimique dans du HF va révéler une porosité ou une rugosité dépendant totalement ou en partie du réseau de champs de contraintes et/ou du réseau de défauts cristallins. En outre, le pas de cette rugosité peut être un multiple du pas de réseau de champs de contraintes et/ou du réseau de défauts cristallins.

Cette modification de volume peut ensuite être utilisée pour l'organisation de matière déposée sur cette surface. Ce dépôt peut se faire par une des techniques de dépôt choisie par exemple parmi les techniques par voie gazeuses (par exemple, l'épitaxie, les CVD, les techniques de jets moléculaires, les pulvérisations), par voie liquide (par exemple, le dépôt de matériaux en solution, l'épitaxie en phase liquide (LPE), le dépôt d'un polymère fondu.) ou solide (par exemple le dépôt d'agrégat solide). Cette matière déposée peut être amorphe (par exemple de l'oxyde ou du nitrure), métallique (par exemple Co, Fe, Ni, Mn, Au, Cu ou d'autres métaux), semi-conductrice (par exemple Si, Ge, SiC, les composés II-IV ou III-V tels que GaN, InP, AsGa, InGaAs,.), supraconductrice, organique ou isolante (par exemple le diamant, le graphite ou d'autres isolants).

## Revendications

1. Procédé permettant de révéler des défauts ou des contraintes dans une structure, comprenant les étapes suivantes :
- collage par adhésion moléculaire d'une face (14) d'un premier élément (1) comprenant du matériau cristallin avec une face (21) d'un deuxième élément (2) comprenant du matériau cristallin, de façon que lesdites faces présentent des réseaux cristallins décalés, le collage provoquant la formation d'un réseau de défauts cristallins (3) et/ou de champs de contraintes au sein d'une zone cristalline au voisinage de l'interface de collage,
- amincissement de l'un (1) des éléments jusqu'à obtenir au moins un film mince (16) adhérant à l'autre élément (2) selon l'interface de collage (14/21) pour constituer ladite structure,
- traitement du film mince (16) conduisant à ce que sa face libre révèle le réseau de défauts cristallins (18) et/ou de champs de contraintes,
**caractérisé en ce que**
- lors de l'étape d'amincissement, l'épaisseur du film mince (16) obtenu est telle que sa face libre (15) ne révèle pas le réseau de défauts cristallins et/ou de champs de contraintes, l'épaisseur du film mince (16) étant aussi telle que l'étape suivante peut être réalisée,
- l'étape de traitement du film mince (16) est choisie parmi un traitement comprenant l'apport d'un budget thermique, un traitement comprenant l'introduction d'espèces chimiques dans le film mince et un traitement comprenant une attaque chimique et/ou une attaque électrochimique et/ou une attaque mécanique et/ou une attaque ionique et/ou une attaque photochimique.

2. Procédé selon la revendication 1, **caractérisé en ce que** le budget thermique est apporté au cours d'une opération ayant pour objet de modifier au moins l'une des propriétés du matériau présenté par la face libre du film mince.

3. Procédé selon la revendication 2, **caractérisé en ce que** lesdites propriétés comprennent sa nature, sa topologie de surface et ses champs de contraintes internes.

4. Procédé selon la revendication 1, **caractérisé en ce que** le budget thermique est apporté au cours d'une opération ayant pour objet d'effectuer un dépôt sur la face libre du film mince.

5. Procédé selon la revendication 1, **caractérisé en ce que** l'introduction d'espèces chimiques est réalisée par une méthode choisie parmi l'implantation ionique et la diffusion.

6. Procédé selon la revendication 1, **caractérisé en ce que** les espèces chimiques introduites sont des espèces qui précipitent sur les défauts cristallins et/ou sous l'influence des champs de contraintes.

7. Procédé selon la revendication 1,
**caractérisé en ce que** le traitement du film mince est réalisé localement pour révéler une ou plusieurs zones du réseau de défauts cristallins et/ou de champs de contraintes.

8. Procédé selon la revendication 1,
**caractérisé en ce que** l'étape d'amincissement fournissant plusieurs films minces adhérents, l'étampe de traitement s'applique à un ou à plusieurs desdits films minces.

## Claims

1. Process permitting defects or stresses in a structure to be revealed, comprising the following steps:
- securing by molecular bonding of a face (14) of a first element (1) containing crystalline material with a face (21) of a second element (2) containing crystalline material, so that said faces have offset crystalline lattices, the securing causing the formation of a lattice of crystalline defects (3) and/or stress fields in the crystalline zone next to the securing interface;
- thinning of one (1) of the elements until at least a thin film (16) is obtained which adheres to the other element (2), along the securing interface (14/21) to form said structure;
- treatment of the thin film (16) resulting in that its free face reveals the crystalline defect lattice (18) and/or the stress fields;
**characterised in that**
- during the thinning step, the thickness of the thin film (16) obtained is such that its free face (15) does not reveal the crystalline defect lattice and/or the stress fields, the thickness of the thin film (16) also being such that the following step is possible;
- the step of treatment of the thin film (16) is chosen from among a treatment comprising the application of a thermal budget, a treatment comprising the introduction of chemical species into the thin film, and a treatment comprising a chemical etching and/or an electrochemical etching and/or a mechanical etching and/or ionic etching and/or a photochemical etching.

2. Process of claim 1 **characterised in that** the thermal budget is applied during an operation whose purpose is to modify at least one of the properties of the material presented by the free face of the thin film.

3. Process of claim 2 **characterised in that** these properties include its nature, its surface topology and its internal stress fields.

4. Process of claim 1 **characterised in that** the thermal budget is applied during an operation, whose purpose is to make a deposit on the free face of the thin film.

5. Process of claim 1 **characterised in that** the chemical species are introduced using a method selected from ionic implantation and diffusion.

6. Process of claim 1 **characterised in that** the chemical species introduced are species which precipitate on the crystalline defects and/or under the influence of the stress fields.

7. Process of claim 1 **characterised in that** the treatment of the thin film is carried out locally to reveal one or more zones of the crystalline defect and/or stress field lattice.

8. Process of claim 1 **characterised in that** the thinning step provides several adhesive thin films, and that the treatment step is applied to one or more of said thin films.

## Patentansprüche

1. Verfahren, das das Aufzeigen von Mängeln oder Spannungen in einer Struktur erlaubt, mit den folgenden Schritten:
- durch molekulares Haften Zusammenkleben einer Seite (14) eines ersten Elements (1), das kristallines Material enthält, mit einer Seite (21) eines zweiten Elements (2), das kristallines Material enthält, derart, dass die Seiten versetzte kristalline Netze aufweisen, wobei das Klebern das Bilden eines Netzes kristalliner Mängel (3) und/oder von Spannungsfeldern innerhalb eines kristallinen Bereichs in der Nähe der Klebeschnittstelle verursacht,
- Verdünnen eines (1) der Elemente bis zum Erzielen eines Dünnfilms (16), der an dem anderen Element (2) gemäß der Klebeschnittfläche (14/21) haftet, um die Struktur zu bilden,
- Behandlung des Dünnfilms (16), die dazu führt, dass seine freie Seite das Netz kristalliner Mängel (18) und/oder Spannungsfelder aufzeigt,
**dadurch gekennzeichnet, dass**
- die beim Verdünnungsschritt erzielte Stärke des Dünnfilms (16) derart ist, dass seine freie Seite (15) das Netz kristalliner Mängel und/oder Spannungsfelder nicht aufzeigt, wobei die Stärke des Dünnfilms (16) auch derart ist, dass der darauf folgende Schritt ausgeführt werden kann,
- der Behandlungsschritt des Dünnfilms (16) ausgewählt wird aus einer Behandlung, die das Zuführen eines Wärmebudgets aufweist, einer Behandlung, die das Einführen chemischer Gattungen in den Dünnfilm und eine Behandlung aufweist, die einen chemischen und/oder elektrochemischen und/oder mechanischen und/oder ionischen und/oder einen photochemischen Angriff aufweist.

2. Verfahren nach Anspruch 1, **dadurch gekennzeichnet, dass** das Wärmebudget im Laufe eines Vorgangs zugeführt wird, der die Aufgabe hat, mindestens eine der Eigenschaften des Materials zu ändern, das von der freien Seite des Dünnfilms präsentiert wird.

3. Verfahren nach Anspruch 2, **dadurch gekennzeichnet, dass** die Eigenschaften seine Beschaffenheit, seine Oberflächentopologie und seine Felder interner Spannungen umfassen.

4. Verfahren nach Anspruch 1, **dadurch gekennzeichnet, dass** das Wärmebudget im Laufe eines Vorgangs zugeführt wird, dessen Aufgabe es ist, auf der freien Seite des Dünnfilms eine Beschichtung auszuführen.

5. Verfahren nach Anspruch 1, **dadurch gekennzeichnet, dass** das Einführen chemischer Gattungen durch ein Verfahren ausgeführt wird, das aus der lonenimplantation und der Diffusion ausgewählt wird.

6. Verfahren nach Anspruch 1, **dadurch gekennzeichnet, dass** die eingeführten chemischen Gattungen Gattungen sind, die sich auf den kristallinen Mängeln und/oder unter dem Einfluss der Spannungsfelder absetzen.

7. Verfahren nach Anspruch 1, **dadurch gekennzeichnet, dass** die Behandlung des Dünnfilms lokal ausgeführt wird, um einen oder mehrere Bereiche des Netzes kristalliner Mängel und/oder Spannungsfelder aufzuzeigen.

8. Verfahren nach Anspruch 1, **dadurch gekennzeichnet, dass** der Verdünnungsschritt mehrere haftende Dünnfilme liefert, wobei der Behandlungsschritt für einen oder mehrere der Dünnfilme gilt.
